# EUROPÄISCHE PATENTSCHRIFT

(11) **EP 0 924 767 B1**
(45) Veröffentlichungstag und Bekanntmachung des Hinweises auf die Patenterteilung: **11.05.2011**
(21) Anmeldenummer: 98121106.3
(22) Anmeldetag: 09.11.1998
(51) Int. Cl.: H01L 27/115, H01L 21/8247

(54) **EEPROM-Anordnung und Verfahren zu deren Herstellung**
EEPROM device and method for manufacturing thereof
Dispositif EEPROM et son procédé de fabrication

(30) Priorität: 22.12.1997 DE 19757336
(43) Veröffentlichungstag der Anmeldung: 23.06.1999
(73) Patentinhaber: Infineon Technologies AG, 85579 Neubiberg (DE)
(72) Erfinder: Hofmann, Franz, Dr., 80995 München (DE); Krautschneider, Wolfgang, 83104 Hohenthann (DE); Willer, Josef, Dr., 85521 Riemerling (DE)
(74) Vertreter: Müller - Hoffmann & Partner

(56) Entgegenhaltungen:
- DE-A- 19 524 478
- US-A- 5 049 956
- PATENT ABSTRACTS OF JAPAN vol. 016, no. 084 (E-1172), 28. Februar 1992 & JP 03 270175 A (OKI ELECTRIC IND CO LTD), 2. Dezember 1991

## Beschreibung

EEPROM-Anordnung mit vertikalen MOS-Transistoren, die jeweils eine elektrisch isolierte erste Gateelektrode umfassen, deren Ladung durch einen Spannungsabfall zwischen einer zweiten Gateelektrode und einem Kanalgebiet verändert werden kann, und Verfahren zu deren Herstellung.

Eine EEPROM-Anordnung ist eine elektrisch schreib- und löschbare Festwertspeicherzellenanordnung. Sie umfaßt Transistoren mit jeweils einer elektrisch isolierten ersten Gateelektrode, die zwischen einer zweiten Gateelektrode und einem Kanalgebiet angeordnet ist. Die Einsatzspannungen der Transistoren können jeweils durch unterschiedliche Ladung auf der ersten Gateelektrode verändert werden. Die Umladung der ersten Gateelektrode erfolgt durch Elektronen, die bei einem hohen Spannungsabfall zwischen der zweiten Gateelektrode und dem Kanalgebiet durch ein dünnes Oxid tunneln.

In der VLSI-Technologie wird eine Erhöhung der Packungsdichte von Schaltungsanordnungen erstrebt, um Prozeßkosten zu senken und Schaltungsgeschwindigkeiten zu erhöhen.

Eine Möglichkeit die Packungsdichte zu erhöhen besteht darin, MOS-Transistoren an Flanken von Halbleiterstrukturen auszubilden (s. z.B. L. Risch, W. H. Krautschneider, F. Hofmann, H. Schäfer, Vertical MOS Transistor with 70 nm channel length, ESSDERC 1995, Seite 101 bis 104). Da der Strom in solchen Transistoren im wesentlichen senkrecht zur Oberfläche eines Substrats verläuft, werden sie als vertikale Transistoren bezeichnet.

In der deutschen Patentanmeldung 19524478 ist eine EEPROM-Anordnung beschrieben, bei der Transistoren an Flanken eines Grabens angeordnet sind. Zwei einander gegenüberliegende Teil-Transistoren teilen sich eine gemeinsame, am Boden des Grabens verlaufende Bitleitung und eine quer zum Graben verlaufende Wortleitung. Zur Erhöhung der Koppelkapazität zwischen einer elektrisch isolierten ersten Gateelektrode und einer zweiten Gateelektrode weisen die ersten Gateelektroden eine größe Ausdehnung parallel zum Kanalverlauf auf, als es der Tiefe des Grabens entspricht. Zur Erzeugung der Wortleitung wird Material geätzt. Dabei entstehen innerhalb des Grabens lochartige Vertiefungen mit einem großem Aspektverhältnis. Durch das große Aspektverhältnis wird der Ätzprozeß erschwert.

In US 5 180 680 ist eine EEPROM-Anordnung beschrieben, bei der in einem Substrat parallel zueinander verlaufende Gräben vorgesehen sind, an deren Flanken sich gegenüberliegende vertikale Transistoren angeordnet sind. Elektrisch isolierte erste Gateelektroden der Transistoren sind in den Gräben angeordnet. In den Gräben verlaufen jeweils zwei Wortleitungen, die teilweise als zweite Gateelektroden wirken. Obere Source/Drain-Gebiete der Transistoren sind zwischen den Gräben angeordnet und sind mit streifenförmigen leitenden Strukturen verbunden, die quer zu den Gräben verlaufen.

In US 5 049 956 ist eine EEPROM-Anordnung beschrieben, bei der in einem Substrat parallel zueinander verlaufende Gräben vorgesehen sind.

Der Erfindung liegt das Problem zugrunde, eine EEPROM-Anordnung mit vertikalen MOS-Transistoren, die jeweils eine elektrisch isolierte erste Gateelektrode umfassen, deren Ladung durch einen Spannungsabfall zwischen einer zweiten Gateelektrode und einem Kanalgebiet verändert werden kann, anzugeben, die im Vergleich zum Stand der Technik bei höherer Prozeßsicherheit mit hoher Packungsdichte herstellbar ist und zugleich für die Umladung einen besonders kleinen Spannungsabfall benötigt. Ferner soll ein Verfahren zur Herstellung einer solchen EEPROM-Anordnung angegeben werden.

Dieses Problem wird gelöst durch eine EEPROM-Anordnung nach Anspruch 1 und ein Verfahren zu deren Herstellung nach Anspruch 5. Weitere Ausgestaltungen der Erfindung gehen aus den übrigen Ansprüchen hervor.

In einer erfindungsgemäßen EEPROM-Anordnung sind vertikale MOS-Transistoren mit jeweils einer elektrisch isolierten ersten Gateelektrode, die zwischen einer zweiten Gateelektrode und einem Kanalgebiet angeordnet ist, vorgesehen. Das Kanalgebiet ist Teil eines Substrats, das einen Graben aufweist, in dem die erste Gateelektrode angeordnet ist. Das mit einem Gatedielektrikum versehene Kanalgebiet ist an einem Teil einer ersten Flanke der ersten Gateelektrode angeordnet. Die Einsatzspannung des MOS-Transistors kann durch unterschiedliche Ladung auf der ersten Gateelektrode verändert werden. Die Umladung der ersten Gateelektrode erfolgt durch Elektronen, die bei einem Spannungsabfall zwischen der zweiten Gateelektrode und dem Kanalgebiet in die erste Gateelektrode oder aus der ersten Gateelektrode tunneln. Damit das Tunneln schon bei einem relativ niedrigen Spannungsabfall erfolgen kann, ist eine große Fläche und damit Koppelkapazität zwischen der ersten Gateelektrode und der zweiten Gateelektrode vorgesehen. In der EEPROM-Anordnung ragt deshalb die erste Gateelektrode aus dem Graben heraus, so daß die erste Flanke der ersten Gateelektrode außerhalb des Grabens liegt. Dadurch kann die Fläche zwischen der ersten Gateelektrode und der zweiten Gateelektrode ohne Verlust an Packungsdichte erhöht werden. Die zweite Gateelektrode grenzt außerhalb des Substrats an die erste Flanke der elektrisch isolierten ersten Gateelektrode und an mindestens einen Teil einer zweiten, der ersten Flanke gegenüberliegenden Flanke der elektrisch isolierten ersten Gateelektrode an. Die zweite Gateelektrode ist Teil einer Wortleitung, die parallel zum Graben verläuft. Damit ein zum Verlauf des Grabens senkrechter Querschnitt der Wortleitung im Bereich zwischen entlang des Grabens zueinander benachbarte erste Gateelektroden nicht kleiner ist als ein analoger Querschnitt der Wortleitung im Bereich der ersten Gateelektroden, ist zwischen jeweils zwei ersten Gateelektroden der MOS-Transistoren, die entlang des Grabens zueinander benachbart sind, eine erste isolierende Struktur angeordnet, die an der Flanke des Grabens angeordnet ist und aus dem Graben herausragt, so daß die ersten Flanken der ersten Gateelektroden und eine erste Flanke der ersten isolierenden Struktur ineinander übergehen. Die Wortleitung grenzt an die erste Flanke der ersten isolierenden Struktur und an mindestens einen Teil einer zweiten, der ersten Flanke gegenüberliegenden Flanke der ersten isolierenden Struktur an. Ohne der ersten isolierenden Struktur wäre ein elektrischer Widerstand der Wortleitung aufgrund abschnittsweise kleiner Querschnitte größer.

Im Gegensatz zur deutschen Patentanmeldung 19524478 können die Wortleitungen selbstjustiert, d.h. ohne Verwendung zu justierender Masken, erzeugt werden. Ist eine vertikale Abmessung der Wortleitungen, d.h. eine Abmessung in einer Ebene der Flanken der Gräben und senkrecht zum Verlauf der Wortleitungen, mit der entsprechenden Abmessung der Wortleitungen der deutschen Patentanmeldung 19524478 vergleichbar, ist der Ätzprozeß zur Erzeugung der Wortleitungen einfacher als zur Erzeugung der senkrecht zu den Gräben verlaufenden Wortleitungen der deutschen Patentanmeldung 19524478. Zwischen den parallel zu den Gräben verlaufenden Wortleitungen entstehen lange Spalten, die mehr Raum für den Gasaustausch beim Atzprozeß gewähren, als die in den Gräben entstehenden lochartigen Vertiefungen zwischen den senkrecht zu den Gräben verlaufenden Wortleitungen der deutschen Patentanmeldung 19524478.

Die erste Gateelektrode kann beispielsweise erzeugt werden, indem durch Abscheiden und Ätzen von Material angrenzend an eine Flanke des Grabens eine Struktur erzeugt wird. Zur Erhöhung der Packungsdichte ist es vorteilhaft, wenn die Struktur ein Spacer ist, der an die Flanke des Grabens angrenzt. Die Struktur kann aber auch durch maskiertes Ätzen erzeugt werden. Es liegt im Rahmen der Erfindung, wenn die Struktur den Graben ausfüllt. Die Höhe der Flanke des Grabens wird nach Erzeugung der Struktur verkleinert, wodurch die Struktur aus dem Graben herausragt und teilweise nicht an das Substrat angrenzt.

Die Flanke des Grabens kann verkleinert werden, indem das Substrat außerhalb des Grabens selektiv zur Struktur geätzt wird. Aus der Struktur werden mehrere erste Gateelektroden erzeugt.

Um zu verhindern, daß das Substrat am Boden des Grabens beim Verkleinern der Flanke des Grabens geätzt wird und dadurch die Flanke nicht verkleinert sondern nur verschoben wird, ist es zur Prozeßvereinfachung vorteilhaft, wenn ein oberer Teil der Flanke des Grabens durch eine Hilfsstruktur gebildet wird, die selektiv zum Substrat ätzbar ist. Die Hilfsstruktur wird vor oder nach Erzeugung eines unteren Teils der Flanke des Grabens, der an das Substrat angrenzt, erzeugt. Zur Verkleinerung der Flanke des Grabens wird die Hilfsstruktur nach Erzeugung der Struktur entfernt. Die Hilfsstruktur wird dabei selektiv zum Substrat geätzt.

Zur Erhöhung der Packungsdichte ist es vorteilhaft, zwei einander gegenüberliegende Transistoren an gegenüberliegenden Flanken des Grabens anzuordnen.

Erste Gateelektroden und zweite Gateelektroden der einander gegenüberliegenden Transistoren können verbunden sein.

Es liegt im Rahmen der Erfindung, wenn die ersten und die zweiten Gateelektroden der einander gegenüberliegenden Transistoren nicht miteinander verbunden sind. Dazu können zur Erhöhung der Packungsdichte die ersten und die zweiten Gateelektroden spacerförmig ausgebildet werden. Pro Graben sind zwei Wortleitungen vorgesehen.

Die Wortleitung kann die Form zweier durchgängiger Spacer aufweisen, die jeweils an die erste Flanke und an die zweite Flanke der ersten Gateelektrode angrenzen.

Es liegt im Rahmen der Erfindung, die erste isolierende Struktur zu erzeugen, indem entlang der Flanken der Gräben jeweils die Struktur erzeugt wird, diese mit einer Schutzschicht bedeckt wird, die Schutzschicht zwischen entlang des Grabens benachbarten Transistoren entfernt wird und freiliegende Teile der Struktur durch thermische Oxidation in die ersten isolierenden Strukturen umgewandelt werden.

Das Volumen der Teile der Struktur, die zur Erzeugung der ersten isolierenden Strukturen aufoxidiert werden, vergrößert sich. Außerhalb des Grabens erfolgt die Oxidation beidseitig, weswegen das Volumen sich symmetrisch sowohl in Richtung Grabenmitte als auch in entgegengesetzter Richtung vergrößert. Innerhalb des Grabens erfolgt die Oxidation nur von einer Seite her, weswegen sich das Volumen nur in Richtung Grabenmitte vergrößern kann. Teile des Grabens werden also durch die ersten isolierenden Strukturen besonders stark verengt. Um einen Kurzschluß zwischen benachbarten Wortleitungen des Grabens zu vermeiden, ist es vorteilhaft, innerhalb des Grabens zwischen einander gegenüberliegenden ersten Gateelektroden und ersten isolierenden Strukturen eine durchgängige zweite isolierende Struktur anzubringen, wobei die Höhe einer oberen Fläche der zweiten isolierenden Struktur größer oder vorzugsweise ungefähr gleich der Höhe einer Oberfläche des Substrats ist. Die Wortleitungen sind dadurch nicht innerhalb des verengten Grabens angeordnet. Vorteilhaft ist auch, daß die Prozeßsicherheit dadurch erhöht wird, da zur Erzeugung der verschiedenen Teile der Wortleitungen die Ätztiefen dieselben sind. Die Ansteuerung der MOS-Transistoren erfolgt über die zweiten Gateelektroden, deren Potentiale sich kapazitiv auf die ersten Gateelektroden übertragen.

Ein oberes Source/Drain-Gebiet und ein unteres Source/Drain-Gebiet des MOS-Transistors können beispielsweise durch maskierte Implantation oder durch Ausdiffusion von Dotierstoff aus einer Dotierstoffquelle in ein Substrat aus Halbleitermaterial, in dem mindestens ein Teil der Flanke des Grabens angeordnet ist, erzeugt werden. Zur Erzeugung des unteren Source/Drain-Gebiets kann die Implantation schräg erfolgen. Zur Prozeßvereinfachung und zur Vermeidung unerwünschter Kapazitäten ist es vorteilhaft, das untere Source/Drain-Gebiete im wesentlichen seitlich versetzt zum oberen Source/Drain-Gebiet anzuordnen. In diesem Fall kann das untere Source/Drain-Gebiet auch durch senkrechte Implantation erzeugt werden. Alternativ wird zur Erzeugung der Source/Drain-Gebiete eine Schichtenfolge auf ein Substrat entsprechend Source/Drain- und Kanalgebieten epitaktisch aufgewachsen, in der mindestens ein Teil der Flanke des Grabens erzeugt wird oder angeordnet ist.

Die Fläche einer Speicherzelle einer erfindungsgemäßen EEPROM-Anordnung kann 2F² betragen, wobei F die minimale, in der jeweiligen Technologie herstellbare Strukturgröße ist. Zur Erhöhung der Packungsdichte ist es vorteilhaft, wenn mehrere quer zu den Gräben benachbarte Transistoren in Reihe geschaltet sind und jeweils zwei obere Source/Drain-Gebiete sowie jeweils zwei untere Source/Drain-Gebiete zusammenfallen, d.h. ein gemeinsames dotiertes Gebiet bilden. Alternativ können obere Source/Drain-Gebiete über eine leitende Struktur miteinander verbunden werden. In diesem Fall sind die Transistoren nicht in Reihe geschaltet. Zur Erhöhung der Packungsdichte ist es vorteilhaft, Kontakte von Wortleitungen eines Grabens jeweils an entgegengesetzten Enden des Grabens anzuordnen.

Die Struktur umfaßt leitendes Material wie z.B. Metall, Silizid oder dotiertes Polysilizium. Polysilizium kann während der Abscheidung dotiert sein oder nachträglich dotiert werden.

Das obere Source/Drain-Gebiet und das untere Source/Drain-Gebiet können n- oder p-dotiert sein.

Im folgenden wird ein Ausführungsbeispiel der Erfindung, das in den Figuren dargestellt ist, näher erläutert.
- Figur 1: zeigt einen Querschnitt durch ein Substrat mit einer dotierten Schicht, nachdem eine erste Hilfsstruktur, Gräben, ein Gatedielektrikum und Strukturen erzeugt wurden.
- Figur 2a: zeigt den Querschnitt aus Figur 1, nachdem eine zweite Hilfsstruktur, untere Source/Drain-Gebiete, obere Source/Drain-Gebiete und eine erste schützende Struktur erzeugt wurden und aus der Struktur erste Gateelektroden und erste isolierende Strukturen (in Figur 2b dargestellt) erzeugt wurden.
- Figur 2b: zeigt einen zum Querschnitt aus Figur 2a parallelen Querschnitt durch das Substrat nach den Prozeßschrit- ten aus Figur 2a.
- Figur 3: zeigt den Schnitt aus Figur 2a, nachdem die erste schützende Struktur entfernt wurde, eine zweite schützende Struktur, zweite isolierende Strukturen, eine dritte isolierende Struktur, Wortleitungen und zweite Gateelektroden erzeugt wurden.

Die Figuren sind nicht maßstabsgerecht.

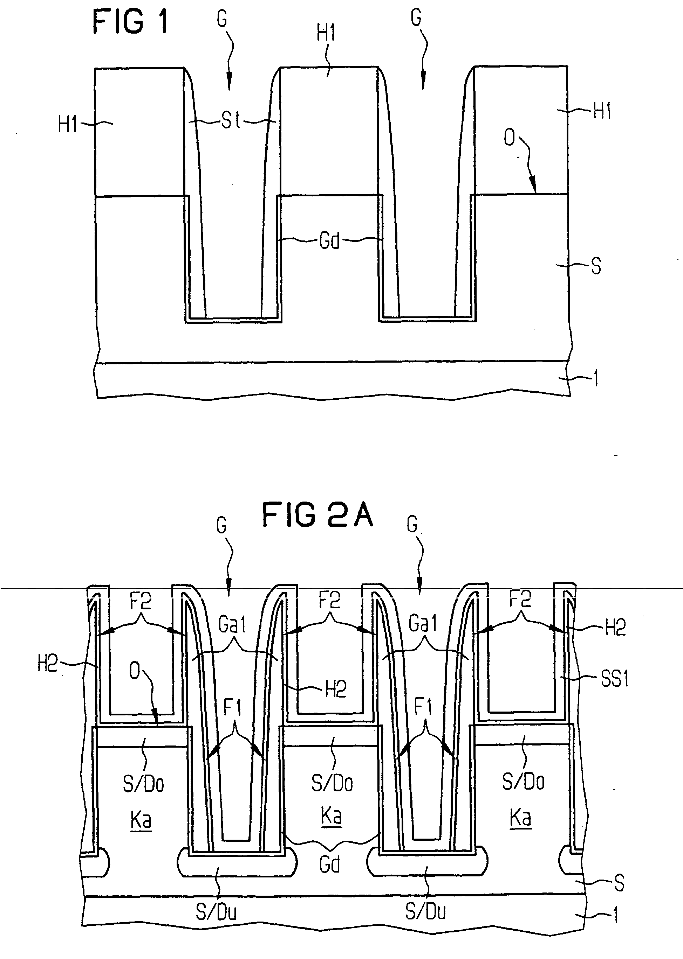

Ausgangsmaterial ist ein Substrat 1 aus Silizium, das in einer an eine Oberfläche O des Substrats 1 angrenzenden ca. 1 µm dicke Schicht S p-dotiert ist (siehe Figur 1). Die Dotierstoffkonzentration der Schicht S beträgt ca. 5*10¹⁷ cm⁻³. Anschließend wird in einem TEOS-Verfahren SiO₂ in einer Dicke von ca. 300 nm abgeschieden. Mit Hilfe einer streifenförmigen ersten Maske (nicht dargestellt) wird SiO₂ mit z.B. CHF₃, O₂ geätzt und dabei parallel zueinander verlaufende ca. 250 nm breite Gräben G erzeugt. Mittellinien zueinander benachbarter Gräben G haben einen Abstand von ca. 250 nm voneinander (siehe Figur 1).

Anschließend wird Silizium selektiv zu SiO₂ mit z.B. HBr, He, O₂, NF₃ bis zu einer Tiefe von ca. 400 nm geätzt, wodurch die Gräben G vertieft werden (s. Figur 1).

Durch thermische Oxidation wird ein ca. 8 nm dickes Gatedielektrikum Gd erzeugt (siehe Figur 1).

Zur Erzeugung von spacerförmigen Strukturen St an Flanken des Grabens G wird insitu dotiertes Polysilizium in einer Dicke von ca. 50 nm abgeschieden und rückgeätzt, bis die erste Hilfsstruktur H1 und an Böden der Gräben G befindliche Teile des Gatedielektrikums Gd teilweise freigelegt werden. Die Strukturen St verlaufen jeweils entlang einer Flanke der Gräben G (s. Fig. 1). Durch Ätzen von SiO₂ selektiv zu Silizium mit z.B. CHF₃, O₂ wird die erste Hilfsstruktur H1 entfernt. Dadurch werden die Flanken der Gräben G verkleinert (siehe Figur 2a). Die Strukturen St ragen nun ca. 300 nm aus den Gräben G hervor.

Durch thermische Oxidation wird eine ca. 10 nm dicke zweite Hilfsstruktur H2 erzeugt (siehe Figur 2a).

Mit Hilfe einer streifenförmigen zweiten Maske (nicht dargestellt) wird eine Implantation mit dotierenden Ionen durchgeführt. Die Streifen der streifenförmigen zweiten Maske verlaufen senkrecht zu den Gräben G und sind ca. 250 nm breit. Der Abstand zwischen Mittellinien benachbarter Streifen beträgt ca. 250 nm. Durch die Implantation entstehen an Teilen der Böden der Gräben G untere Source/Drain-Gebiete S/Du und zwischen den Gräben G obere Source/Drain/Gebiete S/Do (siehe Figur 2a). Die unteren Source/Drain-Gebiete S/Du sind bezüglich einer senkrecht zur Oberfläche O verlaufenden Achse zu den oberen Source/Drain-Gebieten S/Do seitlich versetzt.

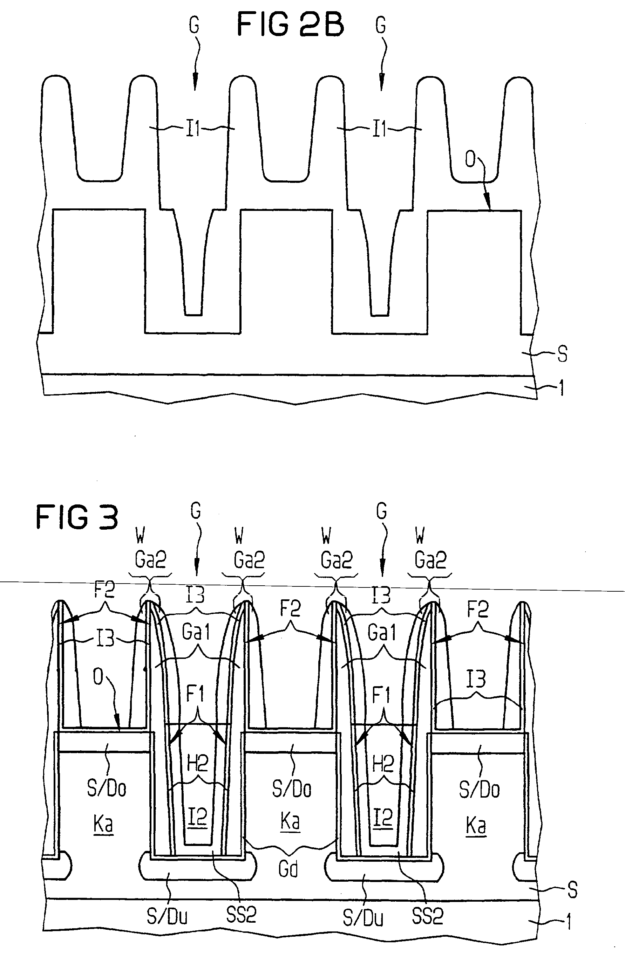

Zur Erzeugung einer ersten schützenden Struktur SS1 wird Siliziumnitrid in einer Dicke von ca. 30 nm abgeschieden und mit Hilfe einer zur zweiten Maske komplementären dritten Maske (nicht dargestellt) geätzt. Als Ätzmittel ist z.B. CF₄, O₂, N₂ geeignet (siehe Figur 2a, die einen Querschnitt durch den von der dritten Maske bedeckten Bereich zeigt, und Figur 2b, die einen zum Querschnitt aus Figur 2a parallelen Querschnitt durch den von der dritten Maske nicht bedeckten Bereichen zeigt).

Durch thermische Oxidation werden von der ersten schützenden Struktur SS1 nicht geschützte Teile der Strukturen St aufoxidiert und bilden erste isolierende Strukturen I1 (siehe Figur 2b). Zwischen den ersten isolierenden Strukturen I1 befindliche Teile der Strukturen St sind als erste Gateelektroden Ga1 geeignet. Da sich das Volumen beim Aufoxidieren vergrößert, und innerhalb der Gräben G die Vergrößerung nur in Richtung Grabenmitte erfolgen kann, ist der Raum zwischen einander gegenüberliegenden ersten isolierenden Strukturen I1 innerhalb der Gräben G kleiner als außerhalb der Gräben, wo die Vergrößerung symmetrisch in Richtung der Grabenmitte und in entgegengesetzter Richtung erfolgen kann (siehe Figur 2b).

Das Volumens der ersten isolierenden Strukturen I1 wird anschließend verkleinert, indem SiO₂ isotrop ca. 50 nm zurückgeätzt wird. Dadurch wird mehr Raum für zu erzeugende Wortleitungen W geschaffen.

Anschließend wird die erste schützende Struktur SS1 mit z.B. H₃PO₄ entfernt.

Zur Erzeugung einer zweiten schützenden Struktur SS2 wird Siliziumnitrid in einer Dicke von ca. 30 nm abgeschieden (siehe Figur 3). Zur Erzeugung einer zweiten isolierenden Struktur I2 wird in einem TEOS-Verfahren SiO₂ in einer Dicke von ca. 200 nm abgeschieden und rückgeätzt, bis innerhalb der Gräben G die zweiten isolierenden Strukturen I2 entstehen, deren Höhe mit der Höhe des Substrats 1 übereinstimmt (siehe Figur 3). Über dem Substrat 1 angeordnete Teile der zweiten schützenden Struktur SS2 dienen dabei als Ätzstop.

Anschließend werden freiliegende Teile der zweiten schützenden Struktur SS2 mit z.B. H₃PO₄ entfernt. Durch isotropes Ätzen von SiO₂ mit z.B. HF werden freiliegende Teile der zweiten Hilfsstruktur H2 entfernt. Eine dritte isolierende Struktur I3, die eine ONO-Schicht umfaßt, wird erzeugt, indem zunächst durch thermische Oxidation eine ca. 3nm dicke Oxidschicht erzeugt wird, anschließend Nitrid in einer Dicke von ca. 15nm abgeschieden und ca. 3nm tief thermisch oxidiert wird (siehe Figur 3).

Zur Erzeugung von Wortleitungen W wird insitu dotiertes Polysilizium in einer Dicke von ca. 50 nm abgeschieden und rückgeätzt. An den ersten Gateelektroden Ga1 angeordnete Teile der Wortleitungen W sind als zweite Gateelektroden Ga2 geeignet. Die Wortleitungen W verlaufen jeweils innerhalb eines Grabens G und außerhalb des Grabens G. Sie grenzen damit jeweils sowohl an eine erste Flanke F1 einer ersten Gateelektrode Ga1, an der auch ein Kanalgebiet eines vertikalen Transistors angrenzt als auch an eine zweite, der ersten Flanke F1 gegenüberliegenden Flanke F2 an (siehe Figur 3). Die dritte isolierende Struktur I3 trennt die ersten Gateelektroden Ga1 von den zweiten Gateelektroden Ga2. Die zweite isolierende struktur I2 verhindert die Bildung der Wortleitungen W innerhalb der verengten Gräben G, wo Kurzschlüsse zwischen benachbarten Wortleitungen W entstehen könnten

Die Einsatzspannung des MOS-Transistors kann durch die Ladung auf der zugehörigen ersten Gateelektrode Ga1 verändert werden. Die Umladung erfolgt durch Tunneln von Elektronen aufgrund eines Spannungsabfalls zwischen der zweiten Gateelektrode Ga2 und dem Kanalgebiet Ka. Der nötige Spannungsabfall ist umso kleiner je größer die Fläche und damit die Koppelkapazität zwischen der ersten Gateelektrode Ga1 und der zweiten Gateelektrode Ga2 ist. Die Größe dieser Fläche wird durch die Dicke der ersten Hilfsstruktur H1 bestimmt.

Es sind viele Variationen des Ausführungsbeispiels denkbar, die ebenfalls im Rahmen der Erfindung liegen. Insbesondere können die Abmessungen der beschriebenen Schichten, Gebiete, Hilfsstrukturen, Strukturen, Masken und Gräben an die jeweiligen Erfordernisse angepaßt werden. Dasselbe gilt auch für die vorgeschlagenen Dotierstoffkonzentrationen: Die Flanken der Gräben müssen nicht senkrecht zur Oberfläche des Substrats verlaufen, sondern können mit der Oberfläche der Halbleiterstruktur einen beliebigen Winkel einschließen. Polysilizium kann sowohl während als auch nach der Abscheidung dotiert werden. Statt dotiertem Polysilizium lassen sich auch z.B. Metallsilizide und/oder Metalle verwenden.

## Patentansprüche

1. EEPROM-Anordnung mit vertikalem MOS-Transistoren, die jeweils eine elektrisch isolierte erste Gateelektrode (Ga1) umfassen, deren Ladung durch einen Spannungsabfall zwischen einer zweiten Gateelektrode (Ga2) und einem Kanalgebiet (Ka) verändert werden kann,
- bei der in einem Stubstrat (1) ein Graben (G) vorgesehen ist, der eine Flanke aufweist, an die das im Substrat (1) angeordnete Kanalgebiet (Ka) angrenzt,
- bei der die erste Gateelektrode (Ga1) an der Flanke des Grabens (G) angeordnet ist und aus dem Graben (G) herausragt,
- bei der zwischen jeweils zwei ersten Gateelektroden (Ga1) der MOS-Transistoren, die entlang des Grabens (G) zueinander benachbart sind, eine erste isolierende Struktur (I1) angeordnet ist,
- bei der die erste isolierende Struktur (I1) an der Flanke des Grabens (G) angeordnet ist und aus dem Graben (G) herausragt, so dass erste Flanken (F1) der ersten Gateelektroden (Ga1) und eine erste Flanke der ersten isolierenden Struktur (I1) ineinander übergehen,
- bei der die erste Flanke (F1) der ersten Gateelektrode (Ga1) dem Kanalgebiet (Ka) zugewandt ist,
- bei der die zweite Gateelektrode (Ga2) außerhalb des Substrats (1) an die erste Flanke (F1) der elektrisch isolierten ersten Gateelektrode (Ga1) und an mindestens einen Teil einer zweiten, der ersten Flanke (F1) gegenüberliegenden Flanke (F2) der elektrisch isolierten ersten Gateelektrode (Ga1) angrenzt,
- bei der die zweite Gateelektrode (Ga2) Teil einer Wortleitung (W) ist, die parallel zum Graben (G) verläuft und die an die erste Flanke der ersten isolierenden Struktur (I1) und an mindestens einen Teil einer zweiten, der ersten Flanke gegenüberliegenden Flanke der ersten isolierenden Struktur (I1) angrenzt, und
- bei der die ersten und die zweiten Gateelektroden der einander gegenüberliegenden Transistoren nicht miteinander verbunden und pro Graben zwei Wortleitungen vorgesehen sind.

2. EEPROM-Anordnung nach Anspruch 1,
- bei der eine erste Gateelektrode (G1) eines anderen der MOS-Transistoren an einer der Flanke des Grabens (G) gegenüberliegenden Flanke des Grabens (G) angeordnet ist, und
- bei der die ersten Gateelektroden (Ga1) und die zweiten Gateelektroden (Ga2) des MOS-Transistors und des anderen MOS-Transistors, die bezüglich des Grabens (G) einander gegenüberliegen, voneinander getrennt sind.

3. EEPROM-Anordnung nach Anspruch 2,
- bei der zwischen den ersten Gateelektroden (Ga1) des MOS-Transistors und des anderen MOS-Transistors eine zweite isolierende Struktur (I2) angeordnet ist, deren obere Fläche oberhalb des Grabens (G) liegt, und
- bei der die zweite Gateelektrode (Ga2) und die Wortleitung (W) oberhalb des Grabens (G) angeordnet sind.

4. EEPROM-Anordnung nach Anspruch 2 oder 3, bei der untere Source/Drain-Gebiete (S/Du) des MOS-Transistors und des anderen MOS-Transistors zusammenfallen und am Boden des Grabens (G) angeordnet sind, und
- bei der obere Source/Drain-Gebiete (S/Do) jener der MOS-Transistoren, die zueinander benachbart sind und an zueinander benachbarten Gräben (G) angeordnet sind, zusammenfallen.

5. Verfahren zur Herstellung einer EEPROM-Anordnung mit vertikalen MOS-Transistoren, die jeweils eine elektrisch isolierte erste Gateelektrode (Ga1) umfassen, deren Ladung durch einen Spannungsabfall zwischen einer zweiten Gateelektrode (Ga2) und einem Kanalgebiet (Ka) verändert werden kann,
- bei dem in einem Substrat (1) in Graben (G) erzeugt wird,
- bei dem im Substrat (1) das Kanalgebiet (Ka) erzeugt wird, so dass es an eine Flanke des Grabens (G) angrenzt,
- bei dem die erste Gateelektrode (Ga1) so erzeugt wird, dass sie an der Flanke des Graben (G) angeordnet ist und aus dem Graben (G) herausragt,
- bei dem zwischen jeweils zwei ersten Gateelektroden (Ga1) der MOS-Transistoren, die entlang des Grabens (G) zueinander benachbart sind, eine erste isolierende Struktur (I1) erzeugt wird, so dass sie an der Flanke des Grabens (G) angeordnet ist, aus dem Graben (G) herausragt und erste Flanken (F1) der ersten Gateelektroden (Ga1) und eine erste Flanke der ersten isolierenden Struktur (I1) ineinander übergehen,
- bei dem die zweite Gateelektrode (Ga2) so erzeugt wird, dass sie außerhalb des Substrats (1) an eine erste Flanke (F1) der elektrisch isolierten ersten Gateelektrode (Ga1), die dem Kanalgebiet (Ka) zugewandt ist, und an mindestens einen Teil einer zweiten, der ersten Flanke (F1) gegenüberliegenden Flanke (F2) der elektrisch isolierten ersten Gateelektrode (Ga1) angrenzt,
- bei dem die zweite Gateelektrode (Ga2) als Teil einer Wortleitung (W) erzeugt wird, die parallel zum Graben (G) verläuft und die an die erste Flanke der ersten isolierenden Struktur (I1) und an mindestens einen Teil einer zweiten, der ersten Flanke gegenüberliegenden Flanke der ersten isolierenden Struktur (I1) angrenzt, und
- bei dem die ersten und die zweiten Gateelektroden der einander gegenüberliegenden Transistoren nicht miteinander verbunden und pro Graben zwei Wortleitungen vorgesehen sind.

6. Verfahren nach Anspruch 5,
- bei dem auf einer Oberfläche (O) des Substrats (1) eine erste Hilfsstruktur (H1) erzeugt wird, indem Material abgeschieden und zusammen mit dem Substrat (1) so geätzt wird, dass ein Graben (G) erzeugt wird, der bis ins Substrat (1) reicht,
- bei dem nach Erzeugung eines Gatedielektrikums (Gd) zur Erzeugung der ersten Gateelektrode (Ga1) Material abgeschieden und rückgeätzt wird, bis die erste Hilfsstruktur (H1) teilweise freigelegt wird, und
- bei dem die erste Hilfsstruktur (H1) entfernt wird.

7. Verfahren nach Anspruch 5 oder 6,
- bei dem eine erste Gateelektrode (G1) eines anderen der MOS-Transistoren an einer der Flanke des Grabens (G) gegenüberliegenden Flanke des Grabens (G) erzeugt wird, so dass der MOS-Transistor und der andere MOS-Transistor bezüglich des Grabens (G) einander gegenüberliegen, und
- bei dem die ersten Gateelektroden (Ga1) und die zweiten Gateelektroden (Ga2) des MOS-Transistors und des anderen MOS-Transistors so erzeugt werden, dass sie voneinander getrennt sind.

8. Verfahren nach Anspruch 7,
- bei dem zur Erzeugung der ersten Gateelektrode (Ga1) entlang den Flanken des Grabens (G) jeweils eine spacerförmige Struktur (St) erzeugt wird,
- bei dem eine schützende Struktur (SS1) erzeugt wird, indem Material abgeschieden und mit Hilfe einer streifenförmigen Maske, deren Streifen quer zum Graben (G) verlaufen, geätzt wird, bis die Struktur (St) teilweise freiliegt, und
- bei dem aus der Struktur (St) die ersten Gateelektroden (Ga1) und zwischen entlang des Grabens (G) zueinander benachbarten ersten Gateelektroden (Ga1) die ersten isolierenden Strukturen (I1) erzeugt werden, indem freiliegende Teile der Struktur (St) durch thermische Oxidation in ein isolierendes Material umgewandelt werden.

9. Verfahren nach Anpruch 7 oder 8,
- bei dem zwischen den ersten Gateelektroden (Ga1) des MOS-Transistors und des anderen MOS-Transistors eine zweite isolierende Struktur (I2) erzeugt wird, deren obere Fläche oberhalb des Grabens (G) liegt, und
- bei dem die zweite Gateelektrode (Ga2) und die Wortleitung (W) so erzeugt werden, dass sie oberhalb des Grabens (G) angeordnet sind.

10. Verfahren nach einem der Ansprüche 7 bis 9,
- bei dem untere Source/Drain-Gebiete (S/Du) des MOS-Transistors und des anderen MOS-Transistors erzeugt werden, die zusammenfallen und am Boden des Grabens (G) angeordnet sind, und
- bei dem obere Source/Drain-Gebiete (S/Do) jener der MOS-Transistoren, die zueinander benachbart sind und an zueinander benachbarte Gräben (G) angeordnet sind, so erzeugt werden, dass sie zusammenfallen.

## Claims

1. EEPROM arrangement comprising vertical MOS transistors each comprising an electrically insulated first gate electrode (Ga1), the charge of which can be altered by a voltage drop between a second gate electrode (Ga2) and a channel region (Ka),
- wherein a trench (G) is provided in a substrate (1), said trench having a sidewall adjoined by the channel region (Ka) arranged in the substrate (1),
- wherein the first gate electrode (Ga1) is arranged on the sidewall of the trench (G) and projects from the trench (G),
- wherein a first insulating structure (I1) is arranged between in each case two first gate electrodes (Ga1) of the MOS transistors which are adjacent to one another along the trench (G),
- wherein the first insulating structure (I1) is arranged on the sidewall of the trench (G) and projects from the trench (G), such that first sidewalls (F1) of the first gate electrodes (Ga1) and a first sidewall of the first insulating structure (I1) merge into one another,
- wherein the first sidewall (F1) of the first gate electrode (GA1) faces the channel region (Ka),
- wherein the second gate electrode (Ga2) outside the substrate (1) adjoins the first sidewall (F1) of the electrically insulated first gate electrode (Ga1) and at least one part of a second sidewall (F2) of the electrically insulated first gate electrode (Ga1), said second sidewall lying opposite the first sidewall (F1),
- wherein the second gate electrode (Ga2) is part of a word line (W) which runs parallel to the trench (G) and which adjoins the first sidewall of the first insulating structure (I1) and at least one part of a second sidewall of the first insulating structure (I1), said second sidewall lying opposite the first sidewall, and
- wherein the first and the second gate electrodes of the transistors lying opposite one another are not connected to one another and two word lines are provided per trench.

2. EEPROM arrangement according to Claim 1,
- wherein a first gate electrode (G1) of another of the MOS transistors is arranged on a sidewall of the trench (G) that lies opposite the sidewall of the trench (G), and
- wherein the first gate electrodes (Ga1) and the second gate electrodes (Ga2) of the MOS transistor and of the other MOS transistor, which lie opposite one another with respect to the trench (G), are separated from one another.

3. EEPROM arrangement according to Claim 2,
- wherein a second insulating structure (I2) is arranged between the first gate electrodes (Ga1) of the MOS transistor and of the other MOS transistor, the upper area of said second insulating structure lying above the trench (G), and
- wherein the second gate electrode (Ga2) and the word line (W) are arranged above the trench (G).

4. EEPROM arrangement according to Claim 2 or 3,
- wherein lower source/drain regions (S/Du) of the MOS transistor and of the other MOS transistor coincide and are arranged at the bottom of the trench (G), and
- wherein upper source/drain regions (S/Do) of those of the MOS transistors which are adjacent to one another and are arranged at mutually adjacent trenches (G) coincide.

5. Method for producing an EEPROM arrangement comprising vertical MOS transistors each comprising an electrically insulated first gate electrode (Ga1) the charge of which can be altered by a voltage drop between a second gate electrode (Ga2) and a channel region (Ka),
- wherein a trench (G) is produced in a substrate (1),
- wherein the channel region (Ka) is produced in the substrate (1), such that it adjoins a sidewall of the trench (G),
- wherein the first gate electrode (Ga1) is produced in such a way that it is arranged on the sidewall of the trench (G) and projects from the trench (G),
- wherein a first insulating structure (I1) is produced between in each case two first gate electrodes (Ga1) of the MOS transistors which are adjacent to one another along the trench (G), such that said first insulating structure is arranged on the sidewall of the trench (G), projects from the trench (G) and first sidewalls (F1) of the first gate electrodes (Ga1) and a first sidewall of the first insulating structure (I1) merge into one another,
- wherein the second gate electrode (Ga2) is produced in such a way that outside the substrate (1) it adjoins a first sidewall (F1) of the electrically insulated first gate electrode (Ga1), which faces the channel region (Ka), and at least one part of a second sidewall (F2) of the electrically insulated first gate electrode (Ga1), said second sidewall lying opposite the first sidewall (F1),
- wherein the second gate electrode (Ga2) is produced as part of a word line (W) which runs parallel to the trench (G) and which adjoins the first sidewall of the first insulating structure (I1) and at least one part of a second sidewall of the first insulating structure (I1), said second sidewall lying opposite the first sidewall, and
- wherein the first and the second gate electrodes of the transistors lying opposite one another are not connected to one another and two word lines are provided per trench.

6. Method according to Claim 5,
- wherein a first auxiliary structure (H1) is produced on a surface (O) of the substrate (1) by material being deposited and etched together with the substrate (1) in such a way as to produce a trench (G) extending right into the substrate (1),
- wherein, after the production of a gate dielectric (Gd), for the production of the first gate electrode (Ga1), material is deposited and etched back until the first auxiliary structure (H1) is partly uncovered, and
- wherein the first auxiliary structure (H1) is removed.

7. Method according to Claim 5 or 6,
- wherein a first gate electrode (G1) of another of the MOS transistors is produced on a sidewall of the trench (G) that lies opposite the sidewall of the trench (G), such that the MOS transistor and the other MOS transistor lie opposite one another with respect to the trench (G), and
- wherein the first gate electrodes (Ga1) and the second gate electrodes (Ga2) of the MOS transistor and of the other MOS transistor are produced in such a way that they are separated from one another.

8. Method according to Claim 7,
- wherein a spacer-type structure (St) is in each case produced in order to produce the first gate electrode (Ga1) along the sidewalls of the trench (G),
- wherein a protective structure (SS1) is produced by material being deposited and etched with the aid of a strip-type mask, the strips of which run transversely with respect to the trench (G), until the structure (St) is partly uncovered, and
- wherein, from the structure (St), the first gate electrodes (Ga1) and, between first gate electrodes (Ga1) adjacent to one another along the trench (G), the first insulating structures (I1) are produced by uncovered parts of the structure (St) being converted into an insulating material by thermal oxidation.

9. Method according to Claim 7 or 8,
- wherein a second insulating structure (I2) is produced between the first gate electrodes (Ga1) of the MOS transistor and of the other MOS transistor, the upper area of said second insulating structure lying above the trench (G), and
- wherein the second gate electrode (Ga2) and the word line (W) are produced in such a way that they are arranged above the trench (G).

10. Method according to any of Claims 7 to 9,
- wherein lower source/drain regions (S/Du) of the MOS transistor and of the other MOS transistor are produced which coincide and are arranged at the bottom of the trench (G), and
- wherein upper source/drain regions (S/Do) of those of the MOS transistors which are adjacent to one another and are arranged at mutually adjacent trenches (G) are produced in such a way that they coincide.

## Revendications

1. Dispositif EEPROM ayant des transistors MOS verticaux, qui comprennent respectivement une première électrode (Ga1) de grille, qui est isolée du point de vue électrique et dont la charge peut être modifiée par une chute de tension entre une deuxième électrode (Ga2) de grille et une zone (Ka) de canal,
- dans lequel il est prévu dans un substrat (1) un sillon (G), qui a un flanc, dont la zone (Ka) de canal disposée dans le substrat (1) est voisine,
- dans lequel la première électrode (Ga1) de grille est disposée sur le flanc du sillon (G) et dépasse du sillon (G),
- dans lequel une première structure (I1) isolante est disposée entre respectivement deux premières électrodes (Ga1) de grille des transistors MOS, qui sont voisines l'une de l'autre le long du sillon (G), ,
- dans lequel la première structure (I1) isolante est disposée sur le flanc du sillon (G) et dépasse du sillon (G), de sorte que des premiers flancs (F1) des premières électrodes (Ga1) de grille et un premier flanc de la première structure (I1) isolante passe de l'un à l'autre,
- dans lequel le premier flanc (F1) de la première électrode (Ga1) de grille est tourné vers la zone (Ka) de canal,
- dans lequel la deuxième électrode (Ga2) de grille à l'extérieur du substrat (1) est voisine du premier flanc (F1) de la première électrode (Ga1) de grille isolée du point de vue électrique et d'au moins une partie d'un deuxième flanc (F2), opposé au premier flanc (F1), de la première électrode (Ga1) de grille isolée du point de vue électrique,
- dans lequel la deuxième électrode (Ga2) de grille fait partie d'une ligne (W) de mot, qui s'étend parallèlement au sillon (G) et qui est voisine du premier flanc de la première structure (I1) isolante et d'au moins une partie d'un deuxième flanc, opposé au premier flanc, de la première structure (I1) isolante, et
- dans lequel les premières et les deuxièmes électrodes de grille des transistors opposés les uns aux autres ne sont pas reliées entre elles et il est prévu deux lignes de mot par sillon.

2. Dispositif EEPROM suivant la revendication 1,
- dans lequel une première électrode (G1) de grille d'un autre des transistors MOS est disposée sur l'un des flancs, opposé au flanc du sillon (G), du sillon, et
- dans lequel les premières électrodes (Ga1) de grille et les deuxièmes électrodes (Ga2) de grille du transistor MOS et de l'autre transistor MOS, qui sont opposées les unes aux autres par rapport au sillon (G), sont séparées les unes des autres.

3. Dispositif EEPROM suivant la revendication 2,
- dans lequel il est disposé entre les premières électrodes (Ga1) de grille du transistor MOS et de l'autre transistor MOS une deuxième structure (I2) isolante, dont la surface supérieure est au-dessus du sillon (G), et
- dans lequel la deuxième électrode (Ga2) de grille et la ligne (W) de mot sont disposées au-dessus du sillon (G).

4. Dispositif EEPROM suivant la revendication 2 ou 3,
- dans lequel des zones (S/Du) inférieures de source/drain du transistor MOS et de l'autre transistor MOS coïncident et sont disposées au fond du sillon (G), et
- dans lequel des zones (S/Do) supérieures de source/drain de chacun des transistors MOS, qui sont voisins les uns des autres et qui sont disposés sur des sillons (G) voisins les uns des autres, coïncident.

5. Procédé de production d'un dispositif EEPROM ayant des transistors MOS verticaux, qui comprennent respectivement une première électrode (Ga1) de grille, qui est isolée du point de vue électrique et dont la charge peut être modifiée par une chute de tension entre une deuxième électrode (Ga2) de grille et une zone (Ka) de canal,
- dans lequel on produit des sillons (G) dans un substrat (1),
- dans lequel on produit la zone (Ka) de canal dans le substrat (1), de manière à ce qu'elle soit voisine d'un flanc du sillon (G),
- dans lequel on produit la première électrode (Ga1) de grille, de manière à ce qu'elle soit disposée sur le flanc du sillon (G) et de manière à ce qu'elle dépasse du sillon (G),
- dans lequel on produit, entre respectivement deux premières électrodes (Ga1) de grille des transistors MOS, qui sont voisines le long du sillon (G), une première structure (I1) isolante, de manière à ce qu'elle soit disposée sur le flanc du sillon (G), qu'elle dépasse du sillon (G) et que des premiers flancs (F1) des premières électrodes (Ga1) de grille et un premier flanc de la première structure (I1) isolante passent de l'un à l'autre,
- dans lequel on produit la deuxième électrode (Ga2) de grille, de manière à ce qu'elle soit voisine à l'extérieur du substrat (1) d'un premier flanc (F1) de la première électrode (Ga1) de grille isolée du point de vue électrique, qui est tournée vers la zone (Ka) de canal, et d'au moins une partie d'un deuxième flanc (F2), opposé au premier flanc (F1), de la première électrode (Ga1) de grille isolée du point de vue électrique,
- dans lequel on produit la deuxième électrode (Ga2) de grille en tant que partie d'une ligne (W) de mot, qui s'étend parallèlement au sillon (G) et qui est voisine du premier flanc de la première structure (I1) isolante et d'au moins une partie d'un deuxième flanc, opposé au premier flanc, de la première structure (I1) isolante, et
- dans lequel on ne relie pas entre elles les premières et les deuxièmes électrodes de grille des transistors opposés les uns aux autres et on prévoit deux lignes de mot par sillon.

6. Procédé suivant la revendication 5,
- dans lequel on produit une première structure (H1) auxiliaire sur une surface (O) du substrat (1) en déposant de la matière et en l'attaquant ensemble avec le substrat (1), de manière à produire un sillon (G), qui va jusque dans le substrat (1),
- dans lequel, après la production d'un diélectrique (Gd) de grille, on dépose et on attaque en retrait du matériau pour la production de la première électrode (Ga1) de grille jusqu'à ce que la première structure (H1) auxiliaire soit en partie mise à nu, et
- dans lequel on élimine la première structure (H1) auxiliaire.

7. Procédé suivant la revendication 5 ou 6,
- dans lequel on produit une première électrode (G1) de grille d'un autre des transistors MOS sur un flanc, opposé au flanc du sillon (G), du sillon (G), de manière à ce que le transistor MOS et l'autre transistor MOS soient opposés l'un à l'autre par rapport au sillon (G), et
- dans lequel on produit des premières électrodes (Ga1) de grille et des deuxièmes électrodes (Ga2) de grille du transistor MOS et de l'autre transistor MOS, de manière à ce qu'elles soient séparées les unes des autres.

8. Procédé suivant la revendication 7,
- dans lequel, pour la production de la première électrode (Ga1) de grille, on produit respectivement une structure (St) en forme d'espaceur le long du flanc du sillon (G),
- dans lequel on produit une structure (SS1) de protection en déposant du matériau et en l'attaquant à l'aide d'un masque en forme de bande, dont les bandes s'étendent transversalement au sillon (G), jusqu'à ce que la structure (St) soit partiellement mise à nu, et
- dans lequel, à partir de la structure (St), on produit les premières électrodes (Ga1) de grille et entre des premières électrodes (Ga1) de grille voisines les unes des autres le long du sillon (G) les premières structures (I1) isolantes, en transformant des parties mises à nu de la structure (St) par oxydation thermique en un matériau isolant.

9. Procédé suivant la revendication 7 ou 8,
- dans lequel on produit entre les premières électrodes (Ga1) de grille du transistor MOS et de l'autre transistor MOS une deuxième structure (I2) isolante, dont la surface supérieure est au-dessus du sillon (G), et
- dans lequel on produit la deuxième électrode (Ga2) de grille et la ligne (W) de mot, de manière à ce qu'elle soit au-dessus du sillon (G).

10. Procédé suivant l'une des revendications 7 à 9,
- dans lequel on produit des zones (S/Du) inférieures de source/drain du transistor MOS et de l'autre transistor MOS, qui coïncident et qui sont disposées au fond du sillon (G), et
- dans lequel on produit des zones (S/Do) supérieures de source/drain de chacun des transistors MS, qui sont voisines les unes des autres et qui sont disposées sur des sillons (G) voisins les uns des autres, de manière à ce qu'elles coïncident.
